# EUROPEAN PATENT APPLICATION

(11) **EP 4 346 009 A1**
(43) Date of publication of application: **03.04.2024**
(21) Application number: 23199543.2
(22) Date of filing: 25.09.2023
(51) Int. Cl.: H01Q 1/27

(54) **ADAPTIVE IMPEDANCE TUNING FOR CAPACITIVE INTERCONNECTS**

(30) Priority: 29.09.2022 US 202217936394
(71) Applicant: Meta Platforms Technologies, LLC, Menlo Park, CA 94025 (US)
(72) Inventor: ISLAM, Md Rashidul, Menlo Park (US); MARTINEZ, Juan Manuel, Menlo Park (US); ZHU, Jiang, Menlo Park (US); LIAO, Huan, Menlo Park (US); WEI, Yonghua, Menlo Park (US); YE, Geng, Menlo Park (US); MARTIN, Bruno Cendon, Menlo Park (US); SU, Wenjing, Menlo Park (US)
(74) Representative: Murgitroyd & Company

(57) **Abstract**

The disclosed system may include a detachable capsule that includes a capsule-side capacitive plate. The system may also include a receiving antenna electrically connected to an antenna-side capacitive plate, and a capacitive sensor electrically connected to the capsule-side capacitive plate. The two plates may be coupled to each other and may transmit RF signals between them. The capacitive sensor may be configured to detect an amount of capacitance between the two capacitive plates. The system may also include an antenna matching tuner electrically connected to the capacitive sensor and to an antenna feed. Then, upon receiving capacitance measurements from the capacitive sensor, the antenna matching tuner may alter various parameters of the antenna feed including impedance matching parameters. Various other apparatuses and mobile wearable devices are also disclosed.

## Description

### FIELD OF THE INVENTION

The present disclosure is generally directed to systems and wearable electronic devices that adaptively tune capacitive connections in mobile electronic devices. For instance, the systems herein may adaptively tune capacitive connections between the detachable capsule and the in-band antenna of a smartwatch.

### BACKGROUND

Mobile electronic devices often use many different types of antennas for communication on different frequency bands. For instance, current smartwatches may implement wide- and multi-band long-term evolution (LTE), global positioning system (GPS), wireless fidelity (WiFi), Bluetooth^{™}, near field communication (NFC), or other types of antennas. These different types of antennas may provide long- and short-range communications with other electronic devices and with networks such as cellular networks or the internet.

However, as mobile devices become ever smaller, the amount of space available for these different types of antennas may be limited. Moreover, because of the small size, the amount of bandwidth achievable on any given antenna may be limited. Still further, because mobile devices such as smartwatches are often designed with metal enclosures, placing multiple different types of antennas in different locations where they can receive sufficient operational signal strength may be complicated. In some instances, the size of the mobile device may be increased to accommodate larger antennas. This increased size may, at least in some cases, improve antenna bandwidth and efficiency. However, larger sizes for smartwatches and other mobile devices may be less desirable, as additional weight and bulk in a mobile (especially wearable) device are typically unwanted. Still further, having a metal enclosure may limit how and where different types of antennas may be placed and operated within a mobile device.

For instance, a mobile electronic device may be provided that includes a receiving antenna that is part of a watch band. The watch band antenna may connect to the detachable capsule via a capacitive connection. For instance, a watch band and a detachable capsule may each have capacitive plates or leads that, when near each other, may form a capacitive connection. This connection may change over time, however, as the detachable capsule is repeatedly removed and reattached to the in-band antenna. In response to these changes in capacitance, the electronic components that rely on this connection may begin to malfunction or stop working entirely.

### SUMMARY OF INVENTION

In accordance with the invention in a first aspect, a system comprises:
a detachable capsule including a capsule-side capacitive plate;
a receiving antenna electrically connected to an antenna-side capacitive plate;
a capacitive sensor electrically connected to the capsule-side capacitive plate, the capacitive sensor being configured to detect an amount of capacitance between the antenna-side capacitive plate and the capsule-side capacitive plate; and
an antenna matching tuner electrically connected to the capacitive sensor and to an antenna feed, wherein, upon receiving one or more capacitance measurements from the capacitive sensor, the antenna matching tuner alters one or more parameters of the antenna feed.

In some embodiments, the receiving antenna is at least partially incorporated into a watchband.

In some embodiments, the watchband includes a watch body interface configured to receive and hold the detachable capsule.

In some embodiments, the capacitive sensor, the capsule-side capacitive plate, the antenna matching tuner, and the antenna feed are incorporated into the detachable capsule.

In some embodiments, the system further comprises at least one radio frequency (RF) choke component.

In some embodiments, the RF choke component is electrically connected to the capacitive sensor.

In some embodiments, the RF choke is configured to at least partially reduce an amount of RF current that flows to the capacitive sensor.

In some embodiments, the RF choke is integrated into the detachable capsule.

In some embodiments, the RF choke component is electrically connected to the antenna-side capacitive plate.

In some embodiments, the RF choke is integrated into a watch body interface that is configured to receive and hold the detachable capsule.

In some embodiments, the system further comprises a second antenna-side capacitive plate in the capsule side or antenna side.

In some embodiments, the capacitive sensor is operable to detect a plurality of capacitance values including between the capsule-side capacitive plate and the antenna-side capacitive plate, between the antenna-side capacitive plate and the second antenna-side capacitive plate, and between the second antenna-side capacitive plate and the capsule-side capacitive plate.

In some embodiments, the antenna matching tuner is operable to alter the one or more parameters of the antenna feed based on at least two of the plurality of detected capacitance values.

In accordance with the invention in a second aspect, a mobile wearable device comprises:
a detachable capsule including a capsule-side capacitive plate;
a receiving antenna electrically connected to an antenna-side capacitive plate;
a capacitive sensor electrically connected to the capsule-side capacitive plate, the capacitive sensor being configured to detect an amount of capacitance between the antenna-side capacitive plate and the capsule-side capacitive plate; and
an antenna matching tuner electrically connected to the capacitive sensor and to an antenna feed, wherein, upon receiving one or more capacitance measurements from the capacitive sensor, the antenna matching tuner alters one or more parameters of the antenna feed.

Thus, for example, the mobile wearable device of the second aspect comprises a system of the first aspect conformed and configured as a mobile wearable device, and features of the various embodiments of the former will be understood to apply to the latter by analogy an vice versa.

In some embodiments, the antenna matching tuner implements different tolerance values when altering the one or more parameters of the antenna feed.

In some embodiments, the different tolerance values are associated with different frequency bands, such that antenna matching is specific for each frequency band.

In some embodiments, the receiving antenna is at least partially incorporated into a watchband.

In some embodiments, the watchband includes a watch body interface configured to receive and hold the detachable capsule.

In some embodiments, the mobile wearable device comprises a smartwatch.

In accordance with the invention in a third aspect, an apparatus comprises:
a detachable capsule including one capacitive plate;
a receiving antenna electrically connected to another capacitive plate;
a capacitive sensor electrically connected to the capsule-side capacitive plate, the capacitive sensor being configured to detect an amount of capacitance between the antenna-side capacitive plate and the transmitting capacitive plate; and
an antenna matching tuner electrically connected to the capacitive sensor and to an antenna feed, wherein, upon receiving one or more capacitance measurements from the capacitive sensor, the antenna matching tuner alters one or more parameters of the antenna feed.

### BRIEF DESCRIPTION OF THE DRAWINGS

The accompanying drawings illustrate a number of exemplary embodiments and are a part of the specification. Together with the following description, these drawings demonstrate and explain various principles of the present disclosure.
FIG. 1A is a plan view of an example wristband system, according to at least one embodiment of the present disclosure.
FIG. 1B is a side view of the example wristband system of FIG. 1A, according to at least one embodiment of the present disclosure.
FIG. 2A is a perspective view of an example wristband system, according to at least one embodiment of the present disclosure.
FIG. 2B is a side view of another example wristband system, according to at least one embodiment of the present disclosure.
FIG. 2C is a perspective view of another example wristband system, according to at least one embodiment of the present disclosure.
FIG. 3A is a perspective view of a watch body interface, according to at least one embodiment of the present disclosure.
FIG. 3B is a perspective view of a watch body, according to at least one embodiment of the present disclosure.
FIG. 4 is a side view of a cross section of a watch body that is docked in a watch body interface, according to at least one embodiment of the present disclosure.
FIG. 5 illustrates an embodiment of parallel capacitive plates with respective transmit and receive sides, according to at least one embodiment of the present disclosure.
Fig. 6 illustrates an alternative embodiment of multiple parallel capacitive plates, according to at least one embodiment of the present disclosure.
FIG. 7 illustrates a diagram that includes components of a watch body system and a watch body interface.
FIGS. 8A-8C illustrate embodiments of a watch body system and a watch body interface in which a gap between capacitive plates has been altered in different ways.
FIG. 9 is an illustration of exemplary augmented-reality glasses that may be used in connection with embodiments of this disclosure.
FIG. 10 is an illustration of an exemplary virtual-reality headset that may be used in connection with embodiments of this disclosure.

Throughout the drawings, identical reference characters and descriptions indicate similar, but not necessarily identical, elements. While the exemplary embodiments described herein are susceptible to various modifications and alternative forms, specific embodiments have been shown by way of example in the drawings and will be described in detail herein. However, the exemplary embodiments described herein are not intended to be limited to the particular forms disclosed. Rather, the present disclosure covers all modifications, equivalents, and alternatives falling within the scope of the appended claims.

### DETAILED DESCRIPTION OF EXEMPLARY EMBODIMENTS

The present disclosure is generally directed to systems and wearable electronic devices that adaptively tune capacitive connections in mobile electronic devices. For instance, the systems herein may adaptively tune capacitive connections between the detachable capsule and the in-band antenna of a smartwatch. In at least some of the embodiments described herein, a mobile electronic device may be provided that includes a receiving antenna that is part of a watch band. The watch band antenna may connect to the detachable capsule via a capacitive connection. For instance, a watch band and a detachable capsule may each have capacitive plates or leads that, when near each other, may form a capacitive connection. This connection may change over time, however, as the detachable capsule is repeatedly removed and reattached to the in-band antenna. In response to these changes in capacitance, the electronic components that rely on this connection may begin to malfunction or stop working entirely.

The embodiments herein, in contrast, may dynamically tune the antennas of a mobile device to account for these differences in a capacitive connection. In some cases, closed-loop antenna tuning solutions may allow wireless devices to adjust for different types of changes using impedance tuning. Such wireless devices would identify a known input transmission power and adjust antenna impedance tuning parameters based on the changes in reflected power/ calculated impedance. These adjustments, however, are based on a known input transmission power. As such, in these systems, adapting to such changes was only possible on the transmission side. In at least some of the embodiments herein, the in-band antenna in a smartwatch may be a receive-only antenna. Accordingly, a tuning system that had worked previously on transmission antennas based on a known transmission power would not work on a receive-only, in-band antenna.

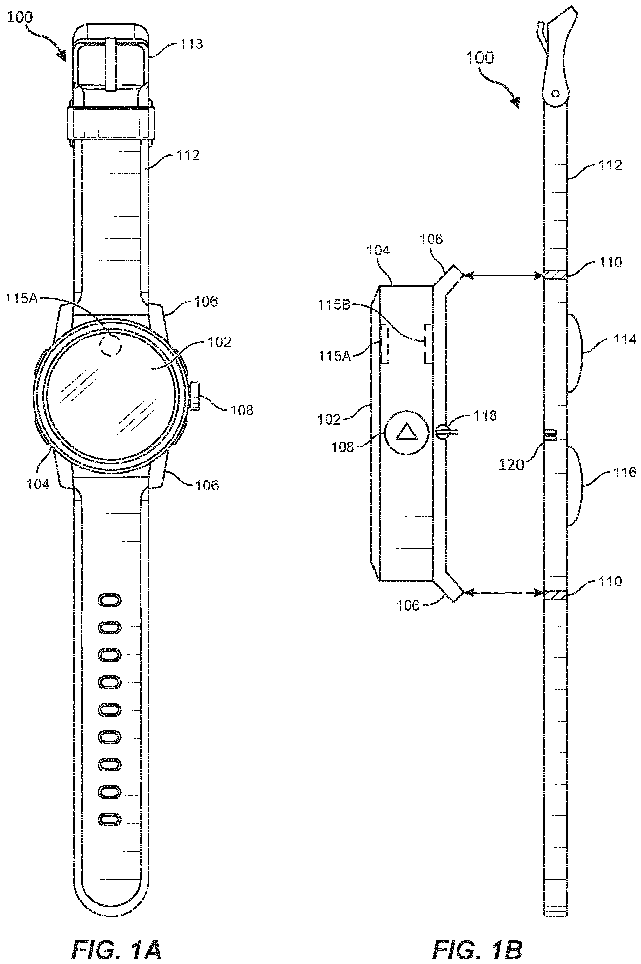

The embodiments described herein may provide an adaptive tuning system that detects changes in capacitance between capacitive interconnect leads (e.g., between a capacitive interconnect lead on a watch capsule and a corresponding lead on a watch band). Based on the detected changes in capacitance between the two capacitive interconnects, the systems herein may adaptively tune the receiving antenna, even in a closed-loop tuning system. The adaptive tuning may allow the watch capsule to continue to operate in real-life conditions, even when food or dust causes the capacitive plates to not fully align. Furthermore, at least in some cases, the systems herein may implement a radio frequency (RF) choke to isolate the various capacitance sensors that are used to sense capacitance between the plates. The RF choke may also ensure that antenna performance is not impacted by blocking (or reducing) RF currents. Each of these embodiments will be described further below with regard to FIGS. 1-10.

Mobile electronic devices often use many different types of antennas for communication on different frequency bands. For instance, current smartwatches may implement wide- and multi-band long-term evolution (LTE), global positioning system (GPS), wireless fidelity (WiFi), Bluetooth^{™}, near field communication (NFC), or other types of antennas. These different types of antennas may provide long- and short-range communications with other electronic devices and with networks such as cellular networks or the internet.

However, as mobile devices become ever smaller, the amount of space available for these different types of antennas may be limited. Moreover, because of the small size, the amount of bandwidth achievable on any given antenna may be limited. Still further, because mobile devices such as smartwatches are often designed with metal enclosures, placing multiple different types of antennas in different locations where they can receive sufficient operational signal strength may be complicated. In some instances, the size of the mobile device may be increased to accommodate larger antennas. This increased size may, at least in some cases, improve antenna bandwidth and efficiency. However, larger sizes for smartwatches and other mobile devices may be less desirable, as additional weight and bulk in a mobile (especially wearable) device are typically unwanted. Still further, having a metal enclosure may limit how and where different types of antennas may be placed and operated within a mobile device.

As noted above, wearable devices may be configured to be worn on a user's body, such as on a user's wrist or arm. Such wearable devices may be configured to perform a variety of functions. A wristband system, for example, may be an electronic device worn on a user's wrist that performs functions such as delivering content to the user, executing social media applications, executing artificial-reality applications, messaging, web browsing, sensing ambient conditions, interfacing with head-mounted displays, monitoring the health status associated with the user, etc. In some examples, a wristband system may include a watch band that detachably couples to a watch body. The watch body may include a coupling mechanism for electrically and mechanically coupling the watch body (e.g., the enclosure or capsule) to the watch band (e.g., the cradle). At least in some cases, the wristband system may have a split architecture that allows the watch band and the watch body to operate both independently and in communication with one another. The mechanical architecture may include a coupling mechanism on the watch band and/or the watch body that allows a user to conveniently attach and detach the watch body from the watch band.

The wristband system of FIGS. 1A and 1B, for example, may be used in isolation or in conjunction with other systems including artificial-reality (AR) systems. Sensors of the wristband system (e.g., image sensors, inertial measurement units (IMUs), etc.) may be used, for example, to enhance an AR application running on the AR system. Further, the watch band may include sensors that measure biometrics of the user. For example, the watch band may include neuromuscular sensors (e.g., neuromuscular sensors 1810 of FIG. 18A) disposed on an inside surface of the watch band contacting the user that detects the muscle intentions of the user. The AR system may include a head-mounted display that is configured to enhance a user interaction with an object within the AR environment based on the muscle intentions of the user. Signals sensed by the neuromuscular sensors may be processed and used to provide a user with an enhanced interaction with a physical object and/or a virtual object in an AR environment. For example, the AR system may operate in conjunction with the neuromuscular sensors to overlay one or more visual indicators on or near an object within the AR environment such that the user could perform "enhanced" or "augmented" interactions with the object.

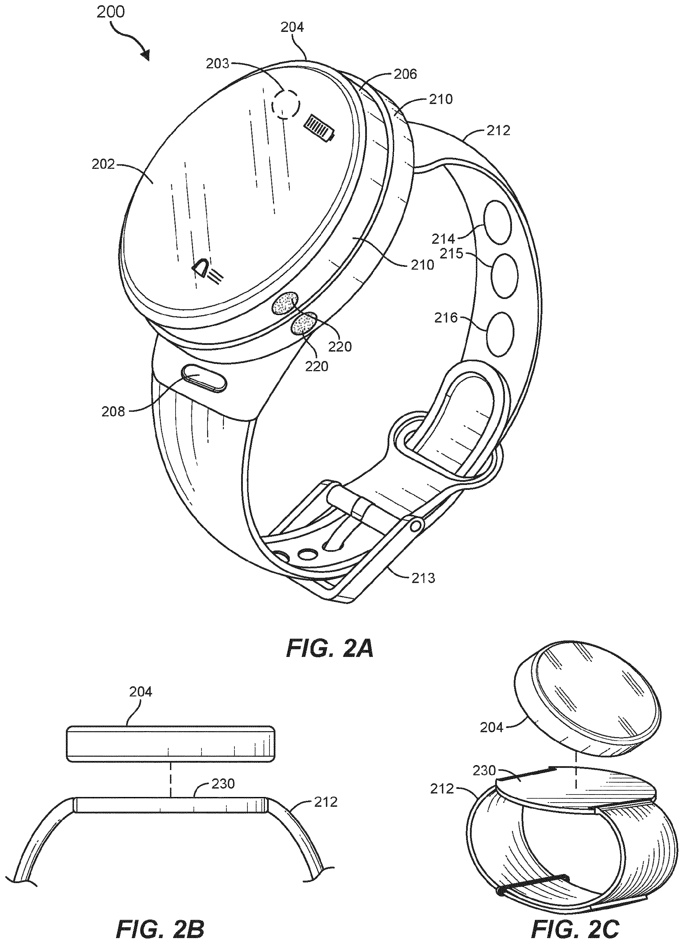

FIGS. 1A and 1B illustrate an embodiment of a wristband system including a watch band and a watch body. In some cases, neuromuscular sensors may be integrated within the wristband system, as shown in FIGS. 2A, 2B, and 2C. FIG. 1A illustrates an example wristband system 100 that includes a watch body 104 coupled to a watch band 112. Watch body 104 and watch band 112 may have any size and/or shape that is configured to allow a user to wear wristband system 100 on a body part (e.g., a wrist). Wristband system 100 may include a retaining mechanism 113 (e.g., a buckle) for securing watch band 112 to the user's wrist. Wristband system 100 may also include a coupling mechanism 106, 110 for detachably coupling watch body 104 to watch band 112. Still further, the wristband system 100 may include a button or wheel 108 that allows users to interact with the wristband system 100 including applications that run on the system.

Wristband system 100 may perform various functions associated with the user. The functions may be executed independently in watch body 104, independently in watch band 112, and/or in communication between watch body 104 and watch band 112. Watch band 112 and its associated antennas may be configured to operate independently (e.g., execute functions independently) from watch body 104. Additionally or alternatively, watch body 104 and its associated antennas may be configured to operate independently (e.g., execute functions independently) from watch band 112. At least in some cases, watch band 112 and/or watch body 104 may each include the independent resources required to independently execute functions. For example, watch band 112 and/or watch body 104 may each include a power source (e.g., a battery), a memory, data storage, a processor (e.g., a CPU), communications (including multiple different types of antennas), a light source (e.g., at least one infrared LED for tracking watch body 104 and/or watch band 112 in space with an external sensor), and/or input/output devices.

FIG. 1B illustrates an example wristband system 100 that includes a watch body 104 decoupled from a watch band 112. Watch band 112 may be donned (e.g., worn) on a body part (e.g., a wrist) of a user and may operate independently from watch body 104. For example, watch band 112 may be configured to be worn by a user and an inner surface of watch band 112 may be in contact with the user's skin. When worn by a user, sensor 114 may be in contact with the user's skin. Sensor 114 may be a biosensor that senses a user's heart rate, bioimpedance, saturated oxygen level, temperature, sweat level, muscle intentions, steps taken, or a combination thereof. Watch band 112 may include multiple sensors 114 and 116 that may be distributed on an inside surface, in an interior volume, and/or on an outside surface of watch band 112. In some examples, watch body 104 may include an electrical connector 118 that mates with connector 120 of watch band 112 for wired communication and/or power transfer. In some examples, as will be described further below, watch body 104 and/or watch band 112 may include wireless communication devices including LTE antennas, GPS antennas, Bluetooth antennas, WiFi antennas, NFC antennas, or other types of antennas.

Wristband system 100 may include a coupling mechanism for detachably coupling watch body 104 to watch band 112. A user may detach watch body 104 from watch band 112 in order to reduce the encumbrance of wristband system 100 to the user. Detaching watch body 104 from watch band 112 may reduce a physical profile and/or a weight of wristband system 100. Wristband system 100 may include a watch body coupling mechanism(s) 106 and/or a watch band coupling mechanism(s) 110. A user may perform any type of motion to couple watch body 104 to watch band 112 and to decouple watch body 104 from watch band 112. For example, a user may twist, slide, turn, push, pull, or rotate watch body 104 relative to watch band 112, or a combination thereof, to attach watch body 104 to watch band 112 and to detach watch body 104 from watch band 112.

As illustrated in FIG. 1B, in some examples, watch body 104 may include front-facing image sensor 115A and rear-facing image sensor 115B. Front-facing image sensor 115A may be located in a front face of watch body 104 (e.g., substantially near, under, or on the display 102), and rear-facing image sensor 115B may be located in a rear face of watch body 104. In some examples, a level of functionality of at least one of watch band 112 or watch body 104 may be modified when watch body 104 is detached from watch band 112. The level of functionality that may be modified may include the functionality of front-facing image sensor 115A and/or rear-facing image sensor 115B. Alternatively, the level of functionality may be modified to change how the various antennas within the system. For instance, as will be described further below, the embodiments herein may include a cosmetic RF transparent feature that may form a functional link between wrist strap antennas and internal electronic components including tuners, amplifiers, controllers, and data processors.

FIG. 2A illustrates a perspective view of an example wristband system 200 that includes a watch body 204 decoupled from a watch band 212. Wristband system 200 may be structured and/or function similarly to wristband system 100 of FIGS. 1A and 1B. Watch body 204 and watch band 212 may have a substantially rectangular or circular shape and may be configured to allow a user to wear wristband system 200 on a body part (e.g., a wrist). Wristband system 200 may include a retaining mechanism 213 (e.g., a buckle, a hook and loop fastener, etc.) for securing watch band 212 to the user's wrist. Wristband system 200 may also include a coupling mechanism 208 for detachably coupling watch body 204 to watch band 212. The watch body 204 may include an enclosure 206 that houses various electronic components. In some cases, the watch body 204 may be referred to as a "capsule."

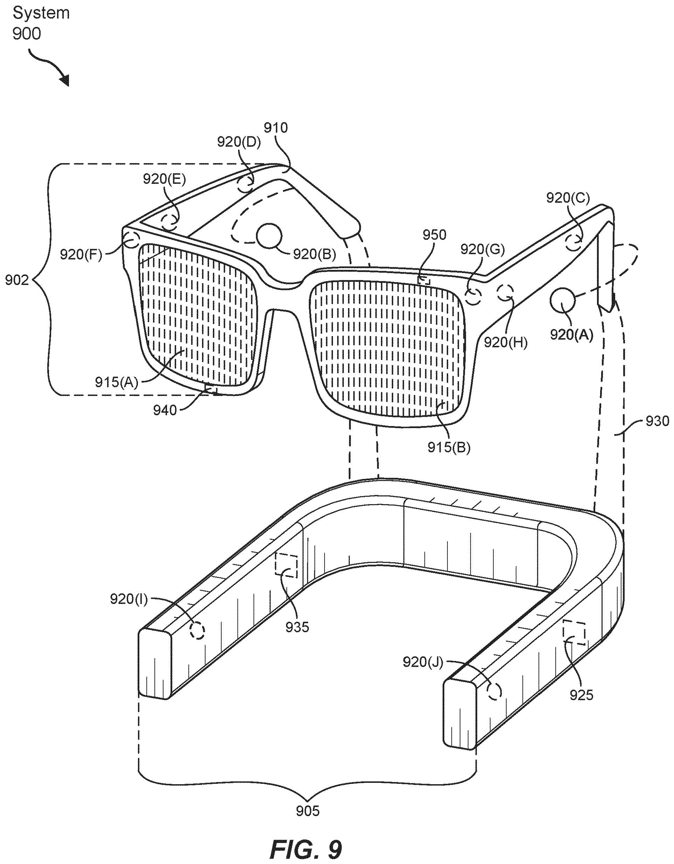

Wristband system 200 may perform various functions associated with the user as described above with reference to FIGS. 1A and 1B. The functions executed by wristband system 200 may include, without limitation, display of visual content to the user (e.g., visual content displayed on display screen 202), sensing user input (e.g., sensing a touch on a touch bezel 210 or on a physical button, sensing biometric data on sensor 214, sensing neuromuscular signals on neuromuscular sensors 215 or 216, sensing audio input via microphones 220, etc.), messaging (e.g., text, speech, video, etc.), image capture (e.g., with a front-facing image sensor 203 and/or a rear-facing image sensor), wireless communications (e.g., cellular, near field, WiFi, personal area network, etc.), location determination, financial transactions, providing haptic feedback, alarms, notifications, biometric authentication, health monitoring, sleep monitoring, etc. These functions may be executed independently in watch body 204, independently in watch band 212, and/or in communication between watch body 204 and watch band 212. Functions may be executed on wristband system 200 in conjunction with an artificial-reality system such as the artificial-reality systems described in FIGS. 9-10.

Watch band 212 may be configured to be worn by a user such that an inner surface of watch band 212 may be in contact with the user's skin. When worn by a user, sensor 214 may be in contact with the user's skin. Sensor 214 may be a biosensor that senses a user's heart rate, saturated oxygen level, temperature, sweat level, muscle intentions, or a combination thereof. Watch band 212 may include multiple sensors 214 that may be distributed on an inside and/or an outside surface of watch band 212. Additionally or alternatively, watch body 204 may include the same or different sensors than watch band 212. For example, multiple sensors may be distributed on an inside and/or an outside surface of watch body 204 or on the surface of the wrist straps. The watch body 204 may include, without limitation, front-facing image sensor 115A, rear-facing image sensor 115B, a biometric sensor, an IMU, a heart rate sensor, a saturated oxygen sensor, a neuromuscular sensor(s), an altimeter sensor, a temperature sensor, a bioimpedance sensor, a pedometer sensor, an optical sensor, a touch sensor, a sweat sensor, etc.

Watch band 212 may transmit the data acquired by sensor 214 to watch body 204 using a wired communication method (e.g., a UART, a USB transceiver, etc.) and/or a wireless communication method (e.g., near field communication, Bluetooth^{™}, etc.). Watch band 212 may be configured to operate (e.g., to collect data using sensor 214) independent of whether watch body 204 is coupled to or decoupled from watch band 212. In some examples, watch band 212 may include a neuromuscular sensor 215 (e.g., an electromyography (EMG) sensor, a mechanomyogram (MMG) sensor, a sonomyography (SMG) sensor, etc.). Neuromuscular sensor 215 may sense a user's muscle intention. Neuromuscular sensor 215 may include neuromuscular sensor 1810 of FIG. 18A.

FIG. 2B is a side view and FIG. 2C is a perspective view of another example wristband system. The wristband systems of FIGS. 2B and 2C may include a watch body interface 230 or "cradle." Watch body 204 may be detachably coupled to watch body interface 230. In additional examples, one or more electronic components may be housed in watch body interface 230 and one or more other electronic components may be housed in portions of watch band 212 away from watch body interface 230.

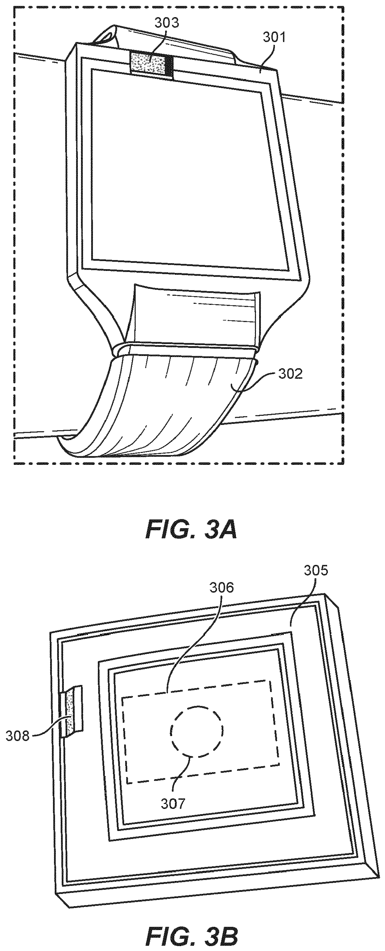

The following will provide, with reference to FIGS. 3-10, detailed descriptions of systems and wearable electronic devices that adaptively tune a capacitive connection between a detachable capsule and an in-band antenna. Features from any of the embodiments described herein may be used in combination with one another in accordance with the general principles described herein. These and other embodiments, features, and advantages will be more fully understood upon reading the following detailed description in conjunction with the accompanying drawings and claims.

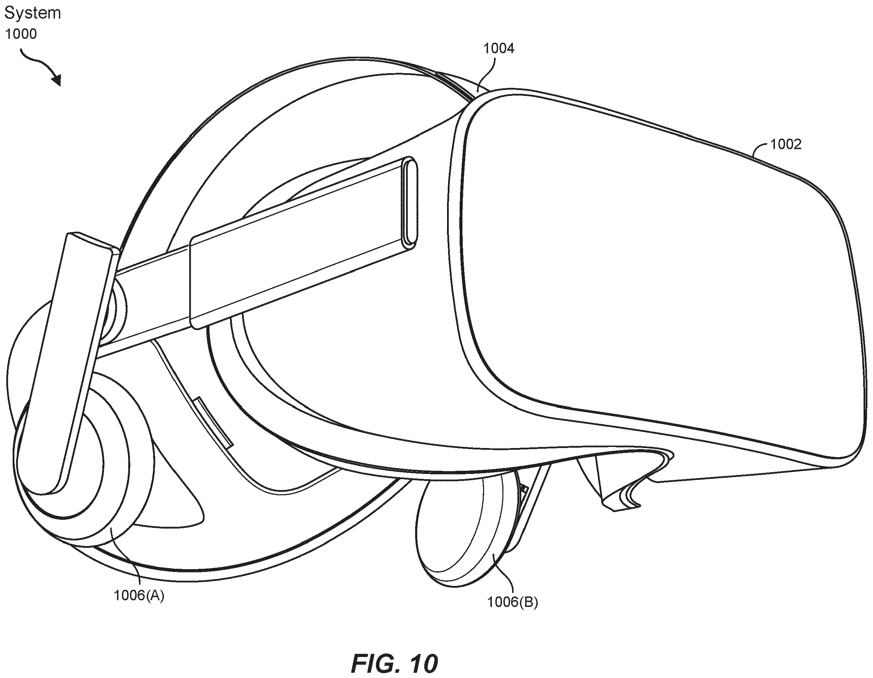

FIG. 3A illustrates an embodiment of a watch body interface 301. The watch body interface 301 may be configured to receive and detachably secure the watch body or capsule 305 of FIG. 3B. The capsule 305 may electrically connect to the watch body interface 301 via a capacitive connection. In some cases, the watch band 302 of the watch body interface 301 may include one or more antennas embedded therein. In some cases, these antennas may be receiving antennas configured to receive LTE cellular data signals or signals on other frequency bands. While many of the embodiments described herein are directed to a smart watch, these same principles may be applied to AR glasses (e.g., 910 of FIG. 9) or to virtual reality headsets (e.g., 1000 of FIG. 10) or to other mobile electronic devices. For instance, the capacitive connections and tuning described herein may occur between the rims or brow line portion of the AR glasses and the temple arms, or between a display screen and a head-mounted securing mechanism on a VR device, or between any other devices or components that electrically connect via a capacitive connection.

Returning FIG. 3A, the watch body interface 301 may include a capacitive plate 303 that may be made of substantially any type of conductive material including metals such as copper. The corresponding watch body or capsule 305 of FIG. 3B may also include a capacitive plate 308. When the capsule 305 is placed on or attached to the watch body interface 301, the capacitive plates 303/308 may be designed to align with one another. Once aligned, the capacitive plates 303/308 may be spaced apart from each other such that a dielectric such as air separates the two plates. Then, when current is applied to one or both of the plates, a capacitive connection may be created between the capsule 305 and the watch body interface 301. The capsule 305 may also include other components 306 including a heart rate sensor 307, a camera, or other components.

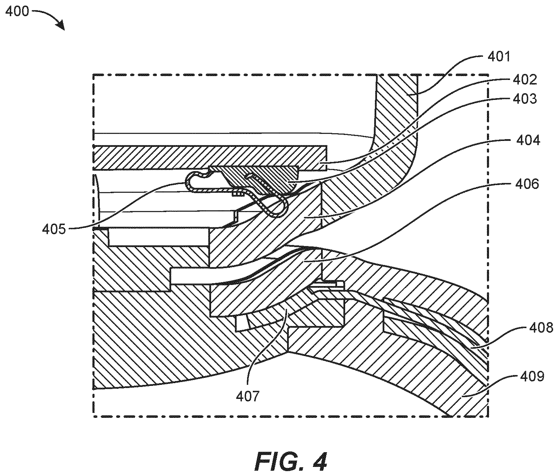

FIG. 4 illustrates a cross-sectional view of a capsule and watch body interface that have been detachably connected. The embodiment 400 of FIG. 4 may include a detachable capsule 401 or watch body that may include a printed circuit board (PCB), one or more electronic components 403, a spring clip 405 or other securing mechanism to connect the antenna feed components to the capacitive plate 404. In some cases, this capacitive plate 404 that is part of the detachable capsule 401 may be referred to as a "capsule-side capacitive plate," while the capacitive plate 406 may be referred to herein as an "antenna-side capacitive plate." The antenna-side capacitive plate 406 may be electrically connected to a receiving antenna 408 via a direct electrical connection 407. This receiving antenna 408 may be embedded in the watchband 409.

In some embodiments, the electronic components 403 may include an antenna feed and/or a capacitive sensor that is electrically connected to the capsule-side capacitive plate 404. The capacitive sensor may be configured to detect an amount of capacitance between the antenna-side capacitive plate 406 and the capsule-side capacitive plate 404. An antenna matching tuner (which may be part of the PCB 402) may be electrically connected to the capacitive sensor and to the antenna feed. Then, upon receiving capacitance measurements from the capacitive sensor, the antenna matching tuner may alter various parameters of the antenna feed including impedance matching values.

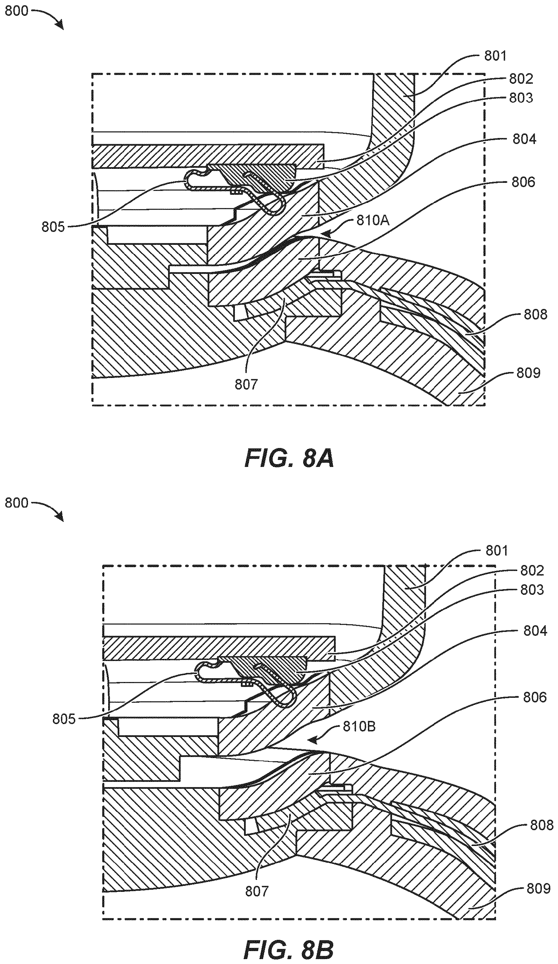

In some cases, the capacitive plates 404 and 406 may become misaligned. For instance, as will be shown further below with regard to FIGS. 8A-8C, the capacitive plates 404 and 406 may be closer together, creating a smaller gap between them. Or, the capacitive plates 404 and 406 may be further apart, creating a larger gap between the plates. Still further, the capacitive plates 404 and 406 may be askew relative to each other, creating a smaller gap on one side and a larger gap on the other side. Moreover, food, dust, lint, or other materials may become embedded over portions or all of the capacitive plates 404 and 406. This may change the properties of the dielectric between the capacitive plates 404 and 406 and may thus change the amount of capacitance detected by the capacitance sensor.

Thus, the capacitance sensor (e.g., part of electronic components 403 affixed to the PCB 402) may continually or continuously take physical capacitance measurements and provide those measurements to a temporary or permanent data store communicatively connected to the PCB 402. The capacitance measurements may then be analyzed by a processor or controller that is communicatively connected to the PCB 402. The processor may determine that changes are to be made to one or more antenna transmission or receiving parameters. These parameters may include changes to impedance matching circuits, changes to shorting locations to tune various antennas, changes in transmission power, amplification, signal processing, or other parameter changes. In some cases, these changes may be made dynamically as new capacitance values are detected. For instance, the detachable capsule 401 may, over time, become less securely attached to the watch body interface. This may cause more regular changes in capacitance between the two capacitive plates 404 and 406. Or, as debris or other objects come between the plates, the detected capacitance values may change. Thus, the sensor may continually take new measurements, and the processor may interpret those measurements and determine which antenna parameters to change and how much of a change to make.

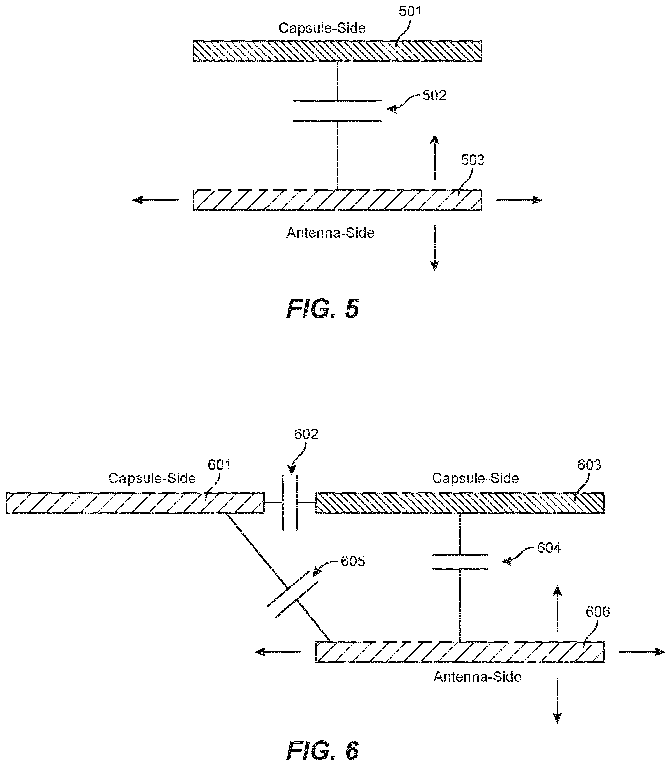

FIGS. 5 and 6 illustrate embodiments in various capacitive plates may be used to create capacitive connections. In one embodiment, as shown in FIG. 5, a capsule-side capacitive plate 501 may be positioned near an antenna-side capacitive plate 503. When the two plates are close enough and when an electrical current is applied to at least one of the plates, a capacitance 502 may be created between the two plates. FIG. 6 illustrates a similar, but more complex scenario where a first capsule-side plate 601 may be placed near a second capsule-side plate 603 and an antenna-side plate 606. Such a scenario may create multiple different capacitance values 602, 604, and 605 between the various capacitive plates. Each of these capacitance values 602, 604, and/or 605 may change over time and may thus provide a more accurate or more highly detailed picture of the connection between a watch body and a watch body interface. For instance, if the antenna-side plate 606 moves close to the first capsule-side plate 601, the capacitance values 604 and 605 may both change, thus providing greater accuracy and a better indication of the watch body's connection to the watch body interface. Stronger capacitive connections may lead to better reception from the receiving in-band antenna that is embedded in the watch's wristband.

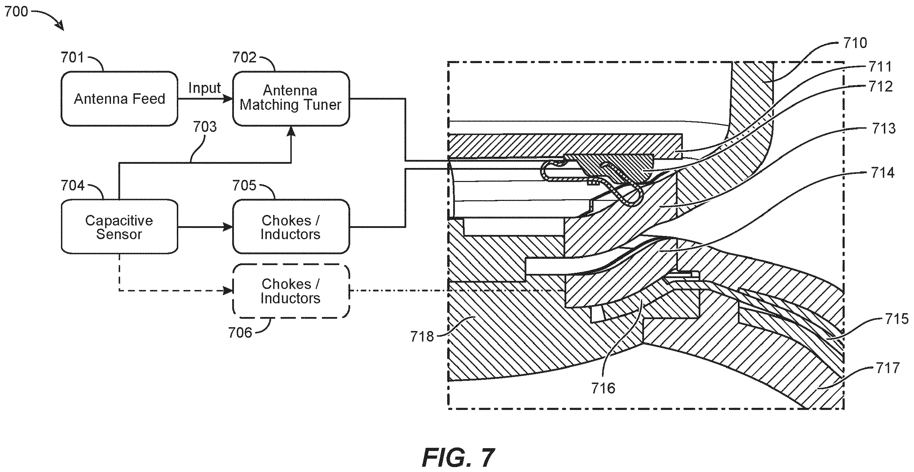

FIG. 7 illustrates an embodiment 700 showing different electronic components that may be part of or affixed to a detachable capsule 710. For example, the electronic components 712 may be part of or affixed to a PCB 711 that is part of the detachable capsule 710. The electronic components 712 may be connected to at least one capacitive plate (e.g., 713) via a spring clip, via a pin, via a trace, or other electrical connection. In some cases, the electronic components 712 may include an antenna feed 701. The antenna feed 701 may include impedance matching circuits, amplifiers, tuners, signal processors, or other associated components. The electronic components 712 may also include an antenna matching tuner 702 that may adjust various antenna parameters upon receiving capacitance measurements 703 from one or more capacitive sensors 704. The antenna matching tuner 702 may change which short connections are used between an antenna and a ground plane, or may change impedance matching characteristics (e.g., increasing or decreasing load impedance), may change the amount of amplification, or may change other antenna parameters to adaptively tune the antenna.

In some cases, as shown in FIG. 7, the capacitive sensor 704, the capsule-side capacitive plate 713, the antenna matching tuner 702, and the antenna feed 701 may be incorporated into the detachable capsule 710. The capacitive sensor 704 may be substantially any type of capacitive sensor including a mutual capacitance sensor, absolute capacitance sensor, or other similar type. The capacitive sensor 704 may be made of one or more different types of materials including copper, indium tin oxide (ITO), printed ink, or other materials. In some cases, the capacitive sensor 704 may be a single sensor, or in other cases, the capacitive sensor 704 may be an array of two or more such sensors.

In some cases, the system of FIG. 7 may include at least one radio frequency (RF) choke component 705 such as an inductor. The RF choke component 705 may be electrically connected to the capacitive sensor 704 and may at least partially reduce the amount of RF current that flows to the capacitive sensor. This may isolate the capacitive sensor 704 from potentially interfering RF currents, and may allow the capacitive sensor 704 to operate more accurately or with greater precision. In some cases, the RF choke component 705 may be integrated into the detachable capsule 710 and may be part of the electronic components 712 on the PCB 711. In some cases, the RF choke component 705 may be electrically connected to the capsule-side capacitive plate 713. In other cases, the RF choke component 705 may be electrically connected to the antenna-side capacitive plate 714.

Additionally or alternatively, a different RF choke component 706 may be connected to the antenna-side capacitive plate 714. This different RF choke component 706 may be integrated into a watch body interface 718 that is configured to receive and hold the detachable capsule 710. Each of these RF choke components may limit RF interference and may improve operating performance and accuracy of the capacitive sensor 704. Such operating performance improvements may include longer battery life due to improved antenna efficiency. This improved antenna efficiency may lead to higher data transfer rates and thus quicker downloads. Quicker downloads may lead to more device sleep time, or at least more antenna sleep time. In this manner, the closed-loop adaptive tuning system described herein may provide better connections between capacitive plates and may, thus, provide improved data transfer and power usage in mobile devices.

The watch body interface 718 may further include an electrical connection 716 between the antenna-side capacitive plate 714 and the in-band antenna 715. The in-band antenna 715 may be a receiving antenna that is at least partially embedded into the watch band 717 and may run for all or a portion of the length of the watch band. In some embodiments, the watch body interface 718 or the detachable capsule 710 may include multiple capacitive plates. Thus, either or both of the watch body interface 718 or the detachable capsule 710 may include multiple capacitive plates, including multiple antenna-side capacitive plates (as shown in FIG. 6), or multiple capsule-side capacitive plates. In such cases, the capacitive sensor 704 may detect multiple capacitance values (e.g., 602, 604, 605) including between the capsule-side capacitive plate and the antenna-side capacitive plate, between the antenna-side capacitive plate and a second antenna-side capacitive plate, and between a second antenna-side capacitive plate and the capsule-side capacitive plate. In response to these detected capacitance values, the antenna matching tuner 702 may alter the various parameters of the antenna feed 701 based on two or more of these different detected capacitance values.

In some embodiments, a mobile wearable device is provided. The mobile wearable device may be a smartwatch, a pair of AR glasses, a VR headset, or other wearable electronic device. The mobile wearable device may include a detachable capsule (e.g., 710) that may include a capsule-side capacitive plate 713, an in-band antenna 715 electrically connected to an antenna-side capacitive plate 714 and a capacitive sensor 704 electrically connected to the capsule-side capacitive plate 713. The capacitive sensor 704 may be configured to detect an amount of capacitance between the antenna-side capacitive plate 714 and the capsule-side capacitive plate 713. The mobile wearable device may further include an antenna matching tuner 702 that is electrically connected to the capacitive sensor 704 and to an antenna feed 701. Upon receiving capacitance measurements 703 from the capacitive sensor 704, the antenna matching tuner 702 may alter various parameters of any components of the antenna feed 701 or parameters of antennas that may be connected to or embedded on the PCB 711.

As will be understood, the mobile wearable device may include many different antennas including cellular (e.g., LTE, 5G, 6G, etc.), WiFi, Bluetooth, global positioning system (GPS), near field communication (NFC), ultrawideband (UWB), or other antennas. Each of these antennas may be configured to operate in different frequency bands. Accordingly, when the antenna matching tuner 702 is altering parameters for these antennas, the antenna matching tuner may take into account the various differences that may exist between bands. For instance, different frequency bands may tolerate different drops in performance or drops in signal due to changes in the capacitive connection between the capsule-side and antenna-side capacitive plates 713/714. Some frequency bands (e.g., lower frequencies such as LTE) may tolerate a reduction in the capacitive connection than higher frequency Bluetooth, WiFi or UWB frequency bands.

Accordingly, the antenna matching tuner 702 may implement different tolerance values when altering the parameters of the antenna feed or the parameters of the antennas themselves. The antenna matching tuner 702 may then alter impedance matching values, amplification values, transmission power values, or other values based on the determined tolerance values. As such, the different tolerance values may be associated with the various frequency bands used by the mobile wearable device, and antenna matching may be specific for each frequency band.

FIGS. 8A-8C illustrate embodiments in which such adjustments may be made. The mobile device 800 of FIGS. 8A-8C may include a bezel or enclosure 801. The enclosure 801 may house various electronic components 803 including a PCB 802 that may have one or more antennas and antenna feeds. The PCB 802 may be connected to a capsule-side capacitive plate 804 via a spring clip 805 or via another type of electrical connection. The capsule-side capacitive plate 804 may capacitively connect to the antenna-side capacitive plate 806 of the watch band 809. The watch band 809 may include an in-band receiving antenna 808 that is connected to the antenna-side capacitive plate 806 via an electrical connection 807. In some cases, the gap between the capacitive plates may change due to misalignment or due to interfering materials.

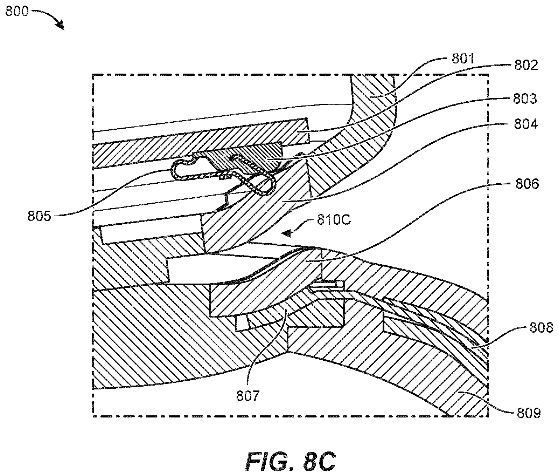

For example, in FIG. 8A, the gap 810A between the capsule-side capacitive plate 804 and the antenna-side capacitive plate 806 may be much smaller than normal. This may cause the capacitive connection between plates to be stronger than normal or may even cause the connection to short. In FIG. 8B, the gap 810B between the capsule-side capacitive plate 804 and the antenna-side capacitive plate 806 may be much larger than normal. This, in turn, may cause the capacitive connection between plates to be weaker than normal. Still further, in FIG. 8C, the capsule-side capacitive plate 804 and the antenna-side capacitive plate 806 may be rotationally askew, with the capsule-side plate being tilted relative to the antenna-side plate. This may reduce or increase the strength of the capacitive connection, depending on how close or how far apart the tilted portions of the plates are in the gap 810C. Furthermore, food, lint, or other elements may become lodged between the capacitive plates, further reducing the strength of the capacitive connection.

In each of these cases, the capacitive sensor (e.g., 704 of FIG. 7) may detect a current capacitance value, provide that value to the antenna matching tuner 702. The antenna matching tuner may then make appropriate adjustments to the antennas and/or antenna feed parameters of the mobile wearable device. In this manner, losses in the capacitive connection between the capacitive plates may be accounted for and compensated by tuning adjustments made by the antenna matching tuner.

### Example Embodiments

Example 1: A system may include a detachable capsule including a capsule-side capacitive plate, a receiving antenna electrically connected to an antenna-side capacitive plate, a capacitive sensor electrically connected to the capsule-side capacitive plate, where the capacitive sensor is configured to detect an amount of capacitance between the antenna-side capacitive plate and the capsule-side capacitive plate, and an antenna matching tuner electrically connected to the capacitive sensor and to an antenna feed, where, upon receiving one or more capacitance measurements from the capacitive sensor, the antenna matching tuner alters one or more parameters of the antenna feed.
Example 2: The system of Example 1, wherein the receiving antenna is at least partially incorporated into a watchband.
Example 3: The system of Example 1 or Example 2, wherein the watchband includes a watch body interface configured to receive and hold the detachable capsule.
Example 4: The system of any of Examples 1-3, wherein the capacitive sensor, the capsule-side capacitive plate, the antenna matching tuner, and the antenna feed are incorporated into the detachable capsule.
Example 5: The system of any of Examples 1-4, further comprising at least one radio frequency (RF) choke component.
Example 6: The system of any of Examples 1-5, wherein the RF choke component is electrically connected to the capacitive sensor.
Example 7: The system of any of Examples 1-6, wherein the RF choke is configured to at least partially reduce an amount of RF current that flows to the capacitive sensor.
Example 8: The system of any of Examples 1-7, wherein the RF choke is integrated into the detachable capsule.
Example 9: The system of any of Examples 1-8, wherein the RF choke component is electrically connected to the antenna-side capacitive plate.
Example 10: The system of any of Examples 1-9, wherein the RF choke is integrated into a watch body interface that is configured to receive and hold the detachable capsule.
Example 11: The system of any of Examples 1-10, further comprising a second antenna-side capacitive plate.
Example 12: The system of any of Examples 1-11, wherein the capacitive sensor detects a plurality of capacitance values including between the capsule-side capacitive plate and the antenna-side capacitive plate, between the antenna-side capacitive plate and the second antenna-side capacitive plate, and between the second antenna-side capacitive plate and the capsule-side capacitive plate.
Example 13: The system of any of Examples 1-12, wherein the antenna matching tuner alters the one or more parameters of the antenna feed based on at least two of the plurality of detected capacitance values.
Example 14: A mobile wearable device may include a detachable capsule including a capsule-side capacitive plate, a receiving antenna electrically connected to an antenna-side capacitive plate, a capacitive sensor electrically connected to the capsule-side capacitive plate, where the capacitive sensor is configured to detect an amount of capacitance between the antenna-side capacitive plate and the capsule-side capacitive plate, and an antenna matching tuner electrically connected to the capacitive sensor and to an antenna feed, wherein, upon receiving one or more capacitance measurements from the capacitive sensor, the antenna matching tuner alters one or more parameters of the antenna feed.
Example 15: The mobile wearable device of Example 14, wherein the antenna matching tuner implements different tolerance values when altering the one or more parameters of the antenna feed.
Example 16: The mobile wearable device of Example 14 or Example 15, wherein the different tolerance values are associated with different frequency bands, such that antenna matching is specific for each frequency band.
Example 17: The mobile wearable device of any of Examples 14-16, wherein the receiving antenna is at least partially incorporated into a watchband.
Example 18: The mobile wearable device of any of Examples 14-17, wherein the watchband includes a watch body interface configured to receive and hold the detachable capsule.
Example 19: The mobile wearable device of any of Examples 14-18, wherein the mobile wearable device comprises a smartwatch.
Example 20: An apparatus comprising: a detachable capsule including a capsule-side capacitive plate, a receiving antenna electrically connected to an antenna-side capacitive plate, a capacitive sensor electrically connected to the capsule-side capacitive plate, where the capacitive sensor is configured to detect an amount of capacitance between the antenna-side capacitive plate and the capsule-side capacitive plate, and an antenna matching tuner electrically connected to the capacitive sensor and to an antenna feed, wherein, upon receiving one or more capacitance measurements from the capacitive sensor, the antenna matching tuner alters one or more parameters of the antenna feed.

Embodiments of the present disclosure may include or be implemented in conjunction with various types of artificial-reality systems. Artificial reality is a form of reality that has been adjusted in some manner before presentation to a user, which may include, for example, a virtual reality, an augmented reality, a mixed reality, a hybrid reality, or some combination and/or derivative thereof. Artificial-reality content may include completely computer-generated content or computer-generated content combined with captured (e.g., real-world) content. The artificial-reality content may include video, audio, haptic feedback, or some combination thereof, any of which may be presented in a single channel or in multiple channels (such as stereo video that produces a three-dimensional (3D) effect to the viewer). Additionally, in some embodiments, artificial reality may also be associated with applications, products, accessories, services, or some combination thereof, that are used to, for example, create content in an artificial reality and/or are otherwise used in (e.g., to perform activities in) an artificial reality.

Artificial-reality systems may be implemented in a variety of different form factors and configurations. Some artificial-reality systems may be designed to work without near-eye displays (NEDs). Other artificial-reality systems may include an NED that also provides visibility into the real world (such as, e.g., augmented-reality system 900 in FIG. 9) or that visually immerses a user in an artificial reality (such as, e.g., virtual-reality system 1000 in FIG. 10). While some artificial-reality devices may be self-contained systems, other artificial-reality devices may communicate and/or coordinate with external devices to provide an artificial-reality experience to a user. Examples of such external devices include handheld controllers, mobile devices, desktop computers, devices worn by a user, devices worn by one or more other users, and/or any other suitable external system.

Turning to FIG. 9, augmented-reality system 900 may include an eyewear device 902 with a frame 910 configured to hold a left display device 915(A) and a right display device 915(B) in front of a user's eyes. Display devices 915(A) and 915(B) may act together or independently to present an image or series of images to a user. While augmented-reality system 900 includes two displays, embodiments of this disclosure may be implemented in augmented-reality systems with a single NED or more than two NEDs.

In some embodiments, augmented-reality system 900 may include one or more sensors, such as sensor 940. Sensor 940 may generate measurement signals in response to motion of augmented-reality system 900 and may be located on substantially any portion of frame 910. Sensor 940 may represent one or more of a variety of different sensing mechanisms, such as a position sensor, an inertial measurement unit (IMU), a depth camera assembly, a structured light emitter and/or detector, or any combination thereof. In some embodiments, augmented-reality system 900 may or may not include sensor 940 or may include more than one sensor. In embodiments in which sensor 940 includes an IMU, the IMU may generate calibration data based on measurement signals from sensor 940. Examples of sensor 940 may include, without limitation, accelerometers, gyroscopes, magnetometers, other suitable types of sensors that detect motion, sensors used for error correction of the IMU, or some combination thereof.

In some examples, augmented-reality system 900 may also include a microphone array with a plurality of acoustic transducers 920(A)-920(J), referred to collectively as acoustic transducers 920. Acoustic transducers 920 may represent transducers that detect air pressure variations induced by sound waves. Each acoustic transducer 920 may be configured to detect sound and convert the detected sound into an electronic format (e.g., an analog or digital format). The microphone array in FIG. 9 may include, for example, ten acoustic transducers: 920(A) and 920(B), which may be designed to be placed inside a corresponding ear of the user, acoustic transducers 920(C), 920(D), 920(E), 920(F), 920(G), and 920(H), which may be positioned at various locations on frame 910, and/or acoustic transducers 920(I) and 920(J), which may be positioned on a corresponding neckband 905.

In some embodiments, one or more of acoustic transducers 920(A)-(J) may be used as output transducers (e.g., speakers). For example, acoustic transducers 920(A) and/or 920(B) may be earbuds or any other suitable type of headphone or speaker.

The configuration of acoustic transducers 920 of the microphone array may vary. While augmented-reality system 900 is shown in FIG. 9 as having ten acoustic transducers 920, the number of acoustic transducers 920 may be greater or less than ten. In some embodiments, using higher numbers of acoustic transducers 920 may increase the amount of audio information collected and/or the sensitivity and accuracy of the audio information. In contrast, using a lower number of acoustic transducers 920 may decrease the computing power required by an associated controller 950 to process the collected audio information. In addition, the position of each acoustic transducer 920 of the microphone array may vary. For example, the position of an acoustic transducer 920 may include a defined position on the user, a defined coordinate on frame 910, an orientation associated with each acoustic transducer 920, or some combination thereof.

Acoustic transducers 920(A) and 920(B) may be positioned on different parts of the user's ear, such as behind the pinna, behind the tragus, and/or within the auricle or fossa. Or, there may be additional acoustic transducers 920 on or surrounding the ear in addition to acoustic transducers 920 inside the ear canal. Having an acoustic transducer 920 positioned next to an ear canal of a user may enable the microphone array to collect information on how sounds arrive at the ear canal. By positioning at least two of acoustic transducers 920 on either side of a user's head (e.g., as binaural microphones), augmented-reality system 900 may simulate binaural hearing and capture a 3D stereo sound field around about a user's head. In some embodiments, acoustic transducers 920(A) and 920(B) may be connected to augmented-reality system 900 via a wired connection 930, and in other embodiments acoustic transducers 920(A) and 920(B) may be connected to augmented-reality system 900 via a wireless connection (e.g., a BLUETOOTH connection). In still other embodiments, acoustic transducers 920(A) and 920(B) may not be used at all in conjunction with augmented-reality system 900.

Acoustic transducers 920 on frame 910 may be positioned in a variety of different ways, including along the length of the temples, across the bridge, above or below display devices 915(A) and 915(B), or some combination thereof. Acoustic transducers 920 may also be oriented such that the microphone array is able to detect sounds in a wide range of directions surrounding the user wearing the augmented-reality system 900. In some embodiments, an optimization process may be performed during manufacturing of augmented-reality system 900 to determine relative positioning of each acoustic transducer 920 in the microphone array.

In some examples, augmented-reality system 900 may include or be connected to an external device (e.g., a paired device), such as neckband 905. Neckband 905 generally represents any type or form of paired device. Thus, the following discussion of neckband 905 may also apply to various other paired devices, such as charging cases, smart watches, smart phones, wrist bands, other wearable devices, hand-held controllers, tablet computers, laptop computers, other external computer devices, etc.

As shown, neckband 905 may be coupled to eyewear device 902 via one or more connectors. The connectors may be wired or wireless and may include electrical and/or non-electrical (e.g., structural) components. In some cases, eyewear device 902 and neckband 905 may operate independently without any wired or wireless connection between them. While FIG. 9 illustrates the components of eyewear device 902 and neckband 905 in example locations on eyewear device 902 and neckband 905, the components may be located elsewhere and/or distributed differently on eyewear device 902 and/or neckband 905. In some embodiments, the components of eyewear device 902 and neckband 905 may be located on one or more additional peripheral devices paired with eyewear device 902, neckband 905, or some combination thereof.

Pairing external devices, such as neckband 905, with augmented-reality eyewear devices may enable the eyewear devices to achieve the form factor of a pair of glasses while still providing sufficient battery and computation power for expanded capabilities. Some or all of the battery power, computational resources, and/or additional features of augmented-reality system 900 may be provided by a paired device or shared between a paired device and an eyewear device, thus reducing the weight, heat profile, and form factor of the eyewear device overall while still retaining desired functionality. For example, neckband 905 may allow components that would otherwise be included on an eyewear device to be included in neckband 905 since users may tolerate a heavier weight load on their shoulders than they would tolerate on their heads. Neckband 905 may also have a larger surface area over which to diffuse and disperse heat to the ambient environment. Thus, neckband 905 may allow for greater battery and computation capacity than might otherwise have been possible on a stand-alone eyewear device. Since weight carried in neckband 905 may be less invasive to a user than weight carried in eyewear device 902, a user may tolerate wearing a lighter eyewear device and carrying or wearing the paired device for greater lengths of time than a user would tolerate wearing a heavy standalone eyewear device, thereby enabling users to more fully incorporate artificial-reality environments into their day-to-day activities.

Neckband 905 may be communicatively coupled with eyewear device 902 and/or to other devices. These other devices may provide certain functions (e.g., tracking, localizing, depth mapping, processing, storage, etc.) to augmented-reality system 900. In the embodiment of FIG. 9, neckband 905 may include two acoustic transducers (e.g., and 920(J)) that are part of the microphone array (or potentially form their own microphone subarray). Neckband 905 may also include a controller 925 and a power source 935.

Acoustic transducers and 920(J) of neckband 905 may be configured to detect sound and convert the detected sound into an electronic format (analog or digital). In the embodiment of FIG. 9, acoustic transducers and 920(J) may be positioned on neckband 905, thereby increasing the distance between the neckband acoustic transducers and 920(J) and other acoustic transducers 920 positioned on eyewear device 902. In some cases, increasing the distance between acoustic transducers 920 of the microphone array may improve the accuracy of beamforming performed via the microphone array. For example, if a sound is detected by acoustic transducers 920(C) and 920(D) and the distance between acoustic transducers 920(C) and 920(D) is greater than, e.g., the distance between acoustic transducers 920(D) and 920(E), the determined source location of the detected sound may be more accurate than if the sound had been detected by acoustic transducers 920(D) and 920(E).

Controller 925 of neckband 905 may process information generated by the sensors on neckband 905 and/or augmented-reality system 900. For example, controller 925 may process information from the microphone array that describes sounds detected by the microphone array. For each detected sound, controller 925 may perform a direction-of-arrival (DOA) estimation to estimate a direction from which the detected sound arrived at the microphone array. As the microphone array detects sounds, controller 925 may populate an audio data set with the information. In embodiments in which augmented-reality system 900 includes an inertial measurement unit, controller 925 may compute all inertial and spatial calculations from the IMU located on eyewear device 902. A connector may convey information between augmented-reality system 900 and neckband 905 and between augmented-reality system 900 and controller 925. The information may be in the form of optical data, electrical data, wireless data, or any other transmittable data form. Moving the processing of information generated by augmented-reality system 900 to neckband 905 may reduce weight and heat in eyewear device 902, making it more comfortable for the user.

Power source 935 in neckband 905 may provide power to eyewear device 902 and/or to neckband 905. Power source 935 may include, without limitation, lithium-ion batteries, lithium-polymer batteries, primary lithium batteries, alkaline batteries, or any other form of power storage. In some cases, power source 935 may be a wired power source. Including power source 935 on neckband 905 instead of on eyewear device 902 may help better distribute the weight and heat generated by power source 935.

As noted, some artificial-reality systems may, instead of blending an artificial reality with actual reality, substantially replace one or more of a user's sensory perceptions of the real world with a virtual experience. One example of this type of system is a head-worn display system, such as virtual-reality system 1000 in FIG. 10, that mostly or completely covers a user's field of view. Virtual-reality system 1000 may include a front rigid body 1002 and a band 1004 shaped to fit around a user's head. Virtual-reality system 1000 may also include output audio transducers 1006(A) and 1006(B). Furthermore, while not shown in FIG. 10, front rigid body 1002 may include one or more electronic elements, including one or more electronic displays, one or more inertial measurement units (IMUs), one or more tracking emitters or detectors, and/or any other suitable device or system for creating an artificial-reality experience.

Artificial-reality systems may include a variety of types of visual feedback mechanisms. For example, display devices in augmented-reality system 900 and/or virtual-reality system 1000 may include one or more liquid crystal displays (LCDs), light emitting diode (LED) displays, microLED displays, organic LED (OLED) displays, digital light projector (DLP) micro-displays, liquid crystal on silicon (LCoS) micro-displays, and/or any other suitable type of display screen. These artificial-reality systems may include a single display screen for both eyes or may provide a display screen for each eye, which may allow for additional flexibility for varifocal adjustments or for correcting a user's refractive error. Some of these artificial-reality systems may also include optical subsystems having one or more lenses (e.g., concave or convex lenses, Fresnel lenses, adjustable liquid lenses, etc.) through which a user may view a display screen. These optical subsystems may serve a variety of purposes, including to collimate (e.g., make an object appear at a greater distance than its physical distance), to magnify (e.g., make an object appear larger than its actual size), and/or to relay (to, e.g., the viewer's eyes) light. These optical subsystems may be used in a non-pupil-forming architecture (such as a single lens configuration that directly collimates light but results in so-called pincushion distortion) and/or a pupil-forming architecture (such as a multi-lens configuration that produces so-called barrel distortion to nullify pincushion distortion).

In addition to or instead of using display screens, some of the artificial-reality systems described herein may include one or more projection systems. For example, display devices in augmented-reality system 900 and/or virtual-reality system 1000 may include microLED projectors that project light (using, e.g., a waveguide) into display devices, such as clear combiner lenses that allow ambient light to pass through. The display devices may refract the projected light toward a user's pupil and may enable a user to simultaneously view both artificial-reality content and the real world. The display devices may accomplish this using any of a variety of different optical components, including waveguide components (e.g., holographic, planar, diffractive, polarized, and/or reflective waveguide elements), light-manipulation surfaces and elements (such as diffractive, reflective, and refractive elements and gratings), coupling elements, etc. Artificial-reality systems may also be configured with any other suitable type or form of image projection system, such as retinal projectors used in virtual retina displays.

The artificial-reality systems described herein may also include various types of computer vision components and subsystems. For example, augmented-reality system 900 and/or virtual-reality system 1000 may include one or more optical sensors, such as two-dimensional (2D) or 3D cameras, structured light transmitters and detectors, time-of-flight depth sensors, single-beam or sweeping laser rangefinders, 3D LiDAR sensors, and/or any other suitable type or form of optical sensor. An artificial-reality system may process data from one or more of these sensors to identify a location of a user, to map the real world, to provide a user with context about real-world surroundings, and/or to perform a variety of other functions.

The artificial-reality systems described herein may also include one or more input and/or output audio transducers. Output audio transducers may include voice coil speakers, ribbon speakers, electrostatic speakers, piezoelectric speakers, bone conduction transducers, cartilage conduction transducers, tragus-vibration transducers, and/or any other suitable type or form of audio transducer. Similarly, input audio transducers may include condenser microphones, dynamic microphones, ribbon microphones, and/or any other type or form of input transducer. In some embodiments, a single transducer may be used for both audio input and audio output.

In some embodiments, the artificial-reality systems described herein may also include tactile (i.e., haptic) feedback systems, which may be incorporated into headwear, gloves, body suits, handheld controllers, environmental devices (e.g., chairs, floormats, etc.), and/or any other type of device or system. Haptic feedback systems may provide various types of cutaneous feedback, including vibration, force, traction, texture, and/or temperature. Haptic feedback systems may also provide various types of kinesthetic feedback, such as motion and compliance. Haptic feedback may be implemented using motors, piezoelectric actuators, fluidic systems, and/or a variety of other types of feedback mechanisms. Haptic feedback systems may be implemented independent of other artificial-reality devices, within other artificial-reality devices, and/or in conjunction with other artificial-reality devices.

By providing haptic sensations, audible content, and/or visual content, artificial-reality systems may create an entire virtual experience or enhance a user's real-world experience in a variety of contexts and environments. For instance, artificial-reality systems may assist or extend a user's perception, memory, or cognition within a particular environment. Some systems may enhance a user's interactions with other people in the real world or may enable more immersive interactions with other people in a virtual world. Artificial-reality systems may also be used for educational purposes (e.g., for teaching or training in schools, hospitals, government organizations, military organizations, business enterprises, etc.), entertainment purposes (e.g., for playing video games, listening to music, watching video content, etc.), and/or for accessibility purposes (e.g., as hearing aids, visual aids, etc.). The embodiments disclosed herein may enable or enhance a user's artificial-reality experience in one or more of these contexts and environments and/or in other contexts and environments.

As detailed above, the computing devices and systems described and/or illustrated herein broadly represent any type or form of computing device or system capable of executing computer-readable instructions, such as those contained within the modules described herein. In their most basic configuration, these computing device(s) may each include at least one memory device and at least one physical processor.

In some examples, the term "memory device" generally refers to any type or form of volatile or non-volatile storage device or medium capable of storing data and/or computer-readable instructions. In one example, a memory device may store, load, and/or maintain one or more of the modules described herein. Examples of memory devices include, without limitation, Random Access Memory (RAM), Read Only Memory (ROM), flash memory, Hard Disk Drives (HDDs), Solid-State Drives (SSDs), optical disk drives, caches, variations or combinations of one or more of the same, or any other suitable storage memory.

In some examples, the term "physical processor" generally refers to any type or form of hardware-implemented processing unit capable of interpreting and/or executing computer-readable instructions. In one example, a physical processor may access and/or modify one or more modules stored in the above-described memory device. Examples of physical processors include, without limitation, microprocessors, microcontrollers, Central Processing Units (CPUs), Field-Programmable Gate Arrays (FPGAs) that implement softcore processors, Application-Specific Integrated Circuits (ASICs), portions of one or more of the same, variations or combinations of one or more of the same, or any other suitable physical processor.

Although illustrated as separate elements, the modules described and/or illustrated herein may represent portions of a single module or application. In addition, in certain embodiments one or more of these modules may represent one or more software applications or programs that, when executed by a computing device, may cause the computing device to perform one or more tasks. For example, one or more of the modules described and/or illustrated herein may represent modules stored and configured to run on one or more of the computing devices or systems described and/or illustrated herein. One or more of these modules may also represent all or portions of one or more special-purpose computers configured to perform one or more tasks.

In addition, one or more of the modules described herein may transform data, physical devices, and/or representations of physical devices from one form to another. Additionally or alternatively, one or more of the modules recited herein may transform a processor, volatile memory, non-volatile memory, and/or any other portion of a physical computing device from one form to another by executing on the computing device, storing data on the computing device, and/or otherwise interacting with the computing device.

In some embodiments, the term "computer-readable medium" generally refers to any form of device, carrier, or medium capable of storing or carrying computer-readable instructions. Examples of computer-readable media include, without limitation, transmission-type media, such as carrier waves, and non-transitory-type media, such as magnetic-storage media (e.g., hard disk drives, tape drives, and floppy disks), optical-storage media (e.g., Compact Discs (CDs), Digital Video Discs (DVDs), and BLU-RAY discs), electronic-storage media (e.g., solid-state drives and flash media), and other distribution systems.

The process parameters and sequence of the steps described and/or illustrated herein are given by way of example only and can be varied as desired. For example, while the steps illustrated and/or described herein may be shown or discussed in a particular order, these steps do not necessarily need to be performed in the order illustrated or discussed. The various exemplary methods described and/or illustrated herein may also omit one or more of the steps described or illustrated herein or include additional steps in addition to those disclosed.

The preceding description has been provided to enable others skilled in the art to best utilize various aspects of the exemplary embodiments disclosed herein. This exemplary description is not intended to be exhaustive or to be limited to any precise form disclosed. Many modifications and variations are possible without departing from the spirit and scope of the present disclosure. The embodiments disclosed herein should be considered in all respects illustrative and not restrictive. Reference should be made to the appended claims and their equivalents in determining the scope of the present disclosure.

Unless otherwise noted, the terms "connected to" and "coupled to" (and their derivatives), as used in the specification and claims, are to be construed as permitting both direct and indirect (i.e., via other elements or components) connection. In addition, the terms "a" or "an," as used in the specification and claims, are to be construed as meaning "at least one of." Finally, for ease of use, the terms "including" and "having" (and their derivatives), as used in the specification and claims, are interchangeable with and have the same meaning as the word "comprising."

## Claims

1. A system comprising:
a detachable capsule including a capsule-side capacitive plate;
a receiving antenna electrically connected to an antenna-side capacitive plate;
a capacitive sensor electrically connected to the capsule-side capacitive plate, the capacitive sensor being configured to detect an amount of capacitance between the antenna-side capacitive plate and the capsule-side capacitive plate; and
an antenna matching tuner electrically connected to the capacitive sensor and to an antenna feed, wherein, upon receiving one or more capacitance measurements from the capacitive sensor, the antenna matching tuner alters one or more parameters of the antenna feed.

2. The system of claim 1, wherein the receiving antenna is at least partially incorporated into a watchband.

3. The system of claim 2, wherein the watchband includes a watch body interface configured to receive and hold the detachable capsule.

4. The system of claim 3, wherein the capacitive sensor, the capsule-side capacitive plate, the antenna matching tuner, and the antenna feed are incorporated into the detachable capsule.

5. The system of any preceding claim, further comprising at least one radio frequency (RF) choke component.

6. The system of claim 5, wherein the RF choke component is electrically connected to the capacitive sensor.

7. The system of claim 6, wherein the RF choke is configured to at least partially reduce an amount of RF current that flows to the capacitive sensor; and/ or
wherein the RF choke is integrated into the detachable capsule.

8. The system of claim 5, wherein the RF choke component is electrically connected to the antenna-side capacitive plate.

9. The system of claim 8, wherein the RF choke is integrated into a watch body interface that is configured to receive and hold the detachable capsule.

10. The system of any preceding claim, further comprising a second antenna-side capacitive plate in the capsule side or antenna side wherein optionally,
the capacitive sensor detects a plurality of capacitance values including between the capsule-side capacitive plate and the antenna-side capacitive plate, between the antenna-side capacitive plate and the second antenna-side capacitive plate, and between the second antenna-side capacitive plate and the capsule-side capacitive plate; and further optionally,
the antenna matching tuner alters the one or more parameters of the antenna feed based on at least two of the plurality of detected capacitance values.

11. A mobile wearable device comprising the system of any one of claims 1 to 10.

12. The mobile wearable device of claim 11, wherein the antenna matching tuner implements different tolerance values when altering the one or more parameters of the antenna feed.

13. The mobile wearable device of claim 12, wherein the different tolerance values are associated with different frequency bands, such that antenna matching is specific for each frequency band.

14. The mobile wearable device of any one of claims 11 to 13, wherein the mobile wearable device comprises a smartwatch.

15. An apparatus comprising:
a detachable capsule including one capacitive plate;
a receiving antenna electrically connected to another capacitive plate;
a capacitive sensor electrically connected to the capsule-side capacitive plate, the capacitive sensor being configured to detect an amount of capacitance between the antenna-side capacitive plate and the transmitting capacitive plate; and
an antenna matching tuner electrically connected to the capacitive sensor and to an antenna feed, wherein, upon receiving one or more capacitance measurements from the capacitive sensor, the antenna matching tuner alters one or more parameters of the antenna feed.
